(19) Europäisches Patentamt
European Patent Office
Office européen des brevets

(11) **EP 3 005 397 B1**

(12) **FASCICULE DE BREVET EUROPEEN**

(45) Date de publication et mention
de la délivrance du brevet:
**10.10.2018 Bulletin 2018/41**

(21) Numéro de dépôt: **14726368.5**

(22) Date de dépôt: **26.05.2014**

(51) Int Cl.:
***H01J 37/12*** *(2006.01)*

(86) Numéro de dépôt international:
**PCT/EP2014/060866**

(87) Numéro de publication internationale:
**WO 2014/191370 (04.12.2014 Gazette 2014/49)**

(54) **LENTILLE ELECTROSTATIQUE A MEMBRANE SEMICONDUCTRICE DIELECTRIQUE**

ELEKTROSTATISCHE LINSE MIT DIELEKTRISCHER HALBLEITENDER MEMBRAN

ELECTROSTATIC LENS HAVING A DIELECTRIC SEMICONDUCTING MEMBRANE

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **31.05.2013 FR 1354992**

(43) Date de publication de la demande:
**13.04.2016 Bulletin 2016/15**

(73) Titulaire: **Commissariat à l'Énergie Atomique et aux Énergies Alternatives 75015 Paris (FR)**

(72) Inventeur: **CONSTANCIAS, Christophe F-38700 Sarcenas (FR)**

(74) Mandataire: **Priori, Enrico Marks & Clerk France Immeuble "Visium" 22, avenue Aristide Briand 94117 Arcueil Cedex (FR)**

(56) Documents cités:
WO-A1-2004/021391    WO-A1-2007/129376
WO-A1-2009/020208    JP-A- 2007 189 117
US-A1- 2004 119 021

• MULLER K: "Phase plates for electron microscopes", OPTIK, WISSENSCHAFTLICHE VERLAG GMBH, DE, vol. 45, no. 1, 1 janvier 1976 (1976-01-01), pages 73-85, XP009134533, ISSN: 0030-4026

• THON F ET AL: "Hochauflösungs-elektronenmikroskopie mit spezialaperturblenden und phasenplatten - [High resolution electron microscopy with special aperture shutters and phase plates]", INTERNATIONAL CONGRESS ON ELECTRON MICROSCOPY : ICEM ; 7, GRENOBLE, 30 AUGUST - 5 SEPTEMBER 1970, SOCIÉTÉ FRANCAISE DE MICROSCOPIE ELECTRONIQUE, FR, vol. 1, 30 août 1970 (1970-08-30), pages 3-4, XP009159615,

**Description**

L'invention concerne les lentilles électrostatiques destinées à la focalisation d'un faisceau de particules chargées, et notamment d'un faisceau d'électrons. Ces lentilles sont utilisées notamment dans les canons à électrons de microscopes électroniques ou d'appareils de lithographie par faisceau d'électrons.

Un but de l'invention est d'améliorer les possibilités de focalisation du faisceau d'électrons émis par une cathode.

On rappelle qu'une lentille électrostatique est constituée dans son principe de la manière suivante : on place sur le trajet du faisceau d'électrons une ou plusieurs électrodes en forme de plaques percées d'un trou à travers lequel passe le faisceau d'électrons. Des potentiels sont appliqués aux électrodes pour induire des champs électriques différents en amont et en aval de chaque électrode. L'interaction entre ces champs électriques et le faisceau d'électrons dévie les électrons et les ramène vers un point ou une zone de focalisation. La distance focale peut être calculée assez simplement en fonction des valeurs des champs électriques et de l'énergie des électrons.

Pour un faisceau d'électrons d'énergie donnée, la focalisation est d'autant plus forte que les champs électriques sont forts et donc d'autant plus forte que les tensions appliquées aux électrodes sont élevées. Mais la focalisation est d'autant plus faible que l'énergie du faisceau est plus forte. Il en résulte une difficulté de focalisation pour les faisceaux d'énergie élevée car il devient nécessaire d'appliquer des tensions très élevées entre des électrodes rapprochées, ce qui engendre des risques de claquage.

Les lentilles électrostatiques de focalisation d'électrons ont par ailleurs un inconvénient qui est le fait qu'elles focalisent aussi bien les électrons que les ions qui ont la même énergie. Il en résulte que si le faisceau d'électrons émis par une cathode et focalisé sur une surface arrache des ions positifs à cette surface, ces ions positifs peuvent remonter le faisceau de l'aval vers l'amont et bombarder la cathode sur laquelle la lentille électrostatique tend à les focaliser ; cela engendre un risque de détérioration de la cathode, ou tout simplement un risque de contamination affectant ses propriétés. C'est la raison pour laquelle on préfère parfois focaliser le faisceau d'électrons par des lentilles électromagnétiques qui n'ont pas cet inconvénient car elles agissent différemment sur les électrons et sur les ions.

Cependant, dans certaines applications on préfère utiliser des lentilles électrostatiques. En effet les lentilles électromagnétiques nécessitent des bobinages, des forts courants, des blindages électromagnétiques, ce qui les rend coûteuses. Les systèmes de focalisation moins coûteux, applicables notamment aux faisceaux d'énergie relativement faibles (moins de 100 keV), utilisent plutôt des lentilles électrostatiques. C'est le cas des systèmes de lithographie à faible énergie, des spectromètres, des canons à électrons de tubes à rayons cathodiques, etc. Par ailleurs, des systèmes de lithographie électronique multifaisceaux pourraient difficilement utiliser des lentilles électromagnétiques en raison de l'encombrement des dispositifs électromagnétiques et doivent donc utiliser des lentilles électrostatiques.

Enfin, il faut rappeler que les lentilles électrostatiques sont affectées d'aberrations géométriques et aberrations chromatiques, ou même des aberrations d'astigmatisme. Il faut tenir compte de ces aberrations et on a déjà proposé des systèmes complexes multipolaires pour les corriger, comme par exemple dans les publications de brevet EP0500179, EP1492151, EP1811540. On a proposé également des grilles conductrices bombées pour déformer les équipotentielles autour d'une ouverture de passage de faisceau dans une électrode d'accélération de canon à électron, dans le but de corriger des aberrations sphériques (brevet US 4567399).

WO2004/021391 divulgue un appareil avec correcteur de membrane pour aberrations d'optiques électroniques à faible énergie.

L'invention propose un perfectionnement pour améliorer les possibilités de focalisation de faisceaux d'électrons par des lentilles électrostatiques.

Pour cela, on propose une lentille électrostatique pourvue d'au moins une électrode conductrice percée d'au moins une ouverture de passage d'un faisceau d'électrons, dans laquelle cette ouverture de passage est fermée au moins partiellement par une membrane mince de matériau semiconducteur non dégénéré transparent aux électrons du faisceau et ayant une permittivité diélectrique relative d'au moins 10, caractérisée en ce que ladite membrane est électriquement reliée à ladite électrode conductrice.

Le matériau est de préférence du silicium ayant un dopage inférieur à $10^{19}$ atomes/cm$^3$ Il peut être aussi de l'arséniure de gallium ou un alliage silicium/germanium.

L'épaisseur de la membrane est de préférence inférieure à 2 micromètres pour n'engendrer qu'une faible atténuation et une faible dispersion du faisceau électronique (pour des faisceaux d'au moins 50 keV).

La présence de la membrane semiconductrice modifie les propriétés de focalisation en réduisant la distance focale pour des valeurs données de champs électriques appliqués, ou en réduisant la valeur des champs électriques nécessaires pour une distance de focalisation donnée. Les risques de claquage sont réduits de ce fait. Cette membrane participe également à la réduction de la remontée d'ions positifs vers la source d'électrons parce qu'elle constitue un obstacle matériel à cette remontée.

De plus, la présence de cette membrane facilite la correction des aberrations de la focalisation, aberrations géométriques ou chromatiques dues à la constitution de la lentille. En effet, pour effectuer certaines corrections, on peut structurer la membrane en modulant son épaisseur par gravure ou par dépôt de matériaux isolants, ou encore en déposant sur la membrane mince un matériau conducteur (non polarisé) gravé selon un motif déterminé. Cette correction d'aberrations par une structuration de la membrane mince est beaucoup plus simple à réaliser que la correction multipolaire envisagée dans l'art antérieur.

L'électrode de la lentille électrostatique peut comporter plusieurs ouvertures de passage d'électrons, fermées chacune par une fine membrane semiconductrice pour laisser passer plusieurs faisceaux électroniques, notamment dans des applications de lithographie multifaisceaux. Chaque membrane peut être structurée.

D'autres caractéristiques et avantages de l'invention apparaîtront à la lecture de la description détaillée qui suit et qui est faite en référence aux dessins annexés dans lesquels :

- la figure 1 représente le principe général d'une lentille électrostatique ;
- la figure 2 représente le principe d'une lentille électrostatique selon l'invention avec une membrane mince semiconductrice ;
- la figure 3 représente l'allure générale du champ électrique le long de l'axe du faisceau en présence de potentiels appliqués aux électrodes de la lentille, la lentille centrale étant obstruée par une membrane mince ;
- la figure 4 représente la configuration des lignes de potentiel et des lignes de champ au voisinage de la membrane ;
- la figure 5 représente la transparence d'une membrane en silicium aux électrons de 50 keV en fonction de son épaisseur ;
- la figure 6 représente la transparence de la membrane aux électrons en fonction de l'énergie du faisceau pour une membrane en silicium et pour diverses épaisseurs ;
- la figure 7 représente en vue de face et en coupe latérale l'électrode centrale avec sa membrane ;
- la figure 8 représente l'électrode centrale avec sa membrane dans une configuration où la membrane n'est pas plane ;
- la figure 9 représente une réalisation dans laquelle la membrane possède une épaisseur variable ;
- la figure 10 représente une réalisation dans laquelle la membrane porte des électrodes métalliques ;
- la figure 11 représente une électrode centrale avec plusieurs ouvertures fermées chacune par une membrane respective pour une lentille multifaisceaux.

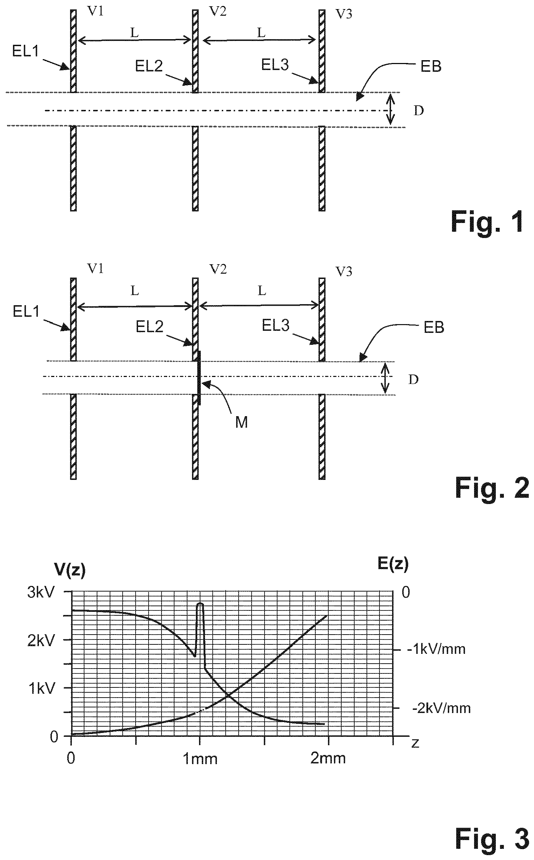

Le principe général d'une lentille électrostatique destinée à la focalisation d'un faisceau d'électrons est rappelé à la figure 1.

Une électrode centrale EL2 est constituée par une plaque conductrice percée d'une ouverture de diamètre D pour le passage d'un faisceau d'électrons EB ; elle est portée à un potentiel V2. Des champs électriques différents de valeur Ea et Eb sont créés de part et d'autre de l'ouverture, et la présence de ces champs différents engendre l'effet de focalisation électrostatique parce qu'ils créent un champ radial au voisinage de l'ouverture dans l'électrode. Ces champs sont créés par exemple par deux autres électrodes EL1 et EL3, respectivement en amont et en aval de l'électrode EL2 dans le sens du trajet du faisceau, portées à des potentiels respectifs V1 et V3. Ces deux autres électrodes sont également percées par des ouvertures pour laisser passer le faisceau d'électrons. Le diamètre du faisceau et donc des ouvertures peut être très petit, jusqu'à quelques dizaines de micromètres, mais il peut aussi être de plusieurs millimètres.

La distance focale F de la lentille électrostatique ainsi constituée est donnée en première approximation par $1/F = - (Eb-Ea)/4Vf$ où Vf est l'énergie du faisceau d'électrons.

Les électrodes sont représentées comme étant des plaques percées d'un trou. Elles pourraient aussi être des cylindres creux juxtaposés le long de l'axe du faisceau, le diamètre intérieur du cylindre constituant le diamètre D de l'ouverture ; les cylindres sont portés à des potentiels différents et l'effet de lentille est produit à la jonction entre deux cylindres.

Le principe de la lentille selon l'invention est représenté à la figure 2. L'ouverture de passage dans l'électrode EL2 est fermée par une membrane mince M en matériau semiconducteur, transparent aux électrons et ayant une forte permittivité relative (supérieure à 10). Dans le cas général, la membrane ferme complètement l'ouverture comme cela est représenté à la figure 2, mais dans certains cas on peut envisager que la fermeture ne soit que partielle, la membrane pouvant être ajourée. Dans l'exemple représenté, la membrane est plane mais on verra qu'elle peut être bombée (en forme de cloche ou de calotte sphérique ou à peu près sphérique).

La conductivité du silicium est faible, son dopage étant inférieur à $10^{19}$ atomes/cm$^3$. Le silicium (ou un autre matériau semiconducteur) doit être non dégénéré, c'est-à-dire que le niveau de Fermi du matériau dopé n ou p ne doit pas être tellement proche de la bande de valence ou de la bande de conduction que le matériau cesserait d'avoir les propriétés d'un semiconducteur et en particulier cesserait d'avoir une conductivité électrique qui augmente avec la température. Un dopage du silicium inférieur à $10^{19}$ atomes/cm$^3$ répond à cette conditon. Il faudrait un dopage de $10^{22}$ à $10^{23}$ at/cm$^3$ pour que le silicium soit dégénéré. La membrane est électriquement reliée à l'électrode centrale, mais sa conductivité limitée fait qu'elle n'est pas portée au même potentiel sur toute sa surface contrairement à ce qui se passerait si elle était en matériau conducteur (métal ou silicium plus fortement dopé ou dégénéré). La figure 3 représente le profil du champ électrique le long de l'axe du faisceau lorsque des potentiels de 10 volts, 200 volts et 2500 volts (valeurs données à titre d'exemple) sont appliqués aux électrodes respectives EL1, EL2, et EL3 situées à des abscisses respectives de 0 millimètre, 1 millimètre, et 2 millimètres (origine placée arbitrairement à l'endroit de la première électrode). Une discontinuité du champ existe à l'endroit de la membrane mince semiconductrice, en raison de la constante diélectrique de la membrane. La discontinuité est d'autant plus grande que la constante diélectrique est plus élevée. Or, la modification du profil du champ électrique le long de l'axe du faisceau entre l'amont et l'aval de l'électrode central est un élément important d'action sur la longueur focale de la lentille. La longueur focale se déduit du calcul des trajectoires des électrons en présence des champs électriques auxquels ils sont soumis. Les trajectoires des électrons se déduisent directement d'une équation qui, si on ne tient pas compte des dérivées du troisième ordre ou plus, c'est-à-dire des aberrations géométriques ou chromatiques, peut s'écrire (pour une lentille à symétrie de révolution) :

$$4V(z)r''(z) + 2\,V'(z)r'(z) + V''(z)r(z) = 0,$$

où $r(z)$ est la distance par rapport à l'axe d'un électron d'abscisse z. L'abscisse est définie le long de l'axe, $V(z)$ est le potentiel sur l'axe optique à l'abscisse (z) où se situe l'électron, $r'(z)$ est la dérivée de r par rapport à l'abscisse z le long de l'axe, $r''(z)$ est la dérivée seconde de r, c'est-à-dire la dérivée de $r'(z)$ par rapport à z, $V'(z)$ est la dérivée de $V(z)$ par rapport à l'abscisse z , et $V''(z)$ est la dérivée seconde de $V(z)$.

Au premier ordre, la différence des champs électriques en amont et en aval de l'électrode centrale EL2 agit directement sur la longueur focale ; donc la dérivée première du potentiel $V(z)$ agit directement sur la longueur focale. Mais au deuxième ordre, la dérivée seconde joue un rôle important dans le calcul des trajectoires et sur la longueur focale ; par conséquent, la présence de la membrane mince de constante diélectrique différente de 1, qui modifie la dérivée seconde du potentiel, modifie la longueur focale.

Dans un exemple de réalisation, on considère que les trois électrodes de la lentille sont séparées par des intervalles successifs de 1 millimètre, le diamètre de l'ouverture centrale fermée par une membrane étant d'environ 0,6 millimètres. On a calculé les modules de champs électrique Ei (à l'entrée de la membrane), Em (au milieu de la membrane), Eo (à la sortie de la membrane) lorsque des potentiels électriques respectifs de 0 volt, 150 volts, et 10 000 volts sont appliqués aux électrodes.

Dans le cas non-revendiqué d'une absence de membrane, la permittivité diélectrique dans le trou de l'électrode centrale est celle du vide donc nulle. Les champs électriques varient peu au cours de la traversée de l'ouverture de l'électrode centrale : Ei = Em = 400 kV/cm.

Dans le cas non-revendiqué d'une membrane conductrice, les modules des champs sont :

$$Ei = 100 \text{ kV/cm, } Em = 0 \text{ V/cm, } Eo = 4 \text{ kV/cm.}$$

La membrane conductrice impose dans l'ouverture de l'électrode centrale un champ électrique radial nul.

Dans le cas d'une membrane diélectrique de forte permittivité, en silicium dopé à moins de $10^{19}$ atomes/cm$^3$, les modules des champs sont :

$$Ei = 100 \text{ kV/cm, } Em = 500 \text{ V/cm, } Eo = 400 \text{ kV/cm.}$$

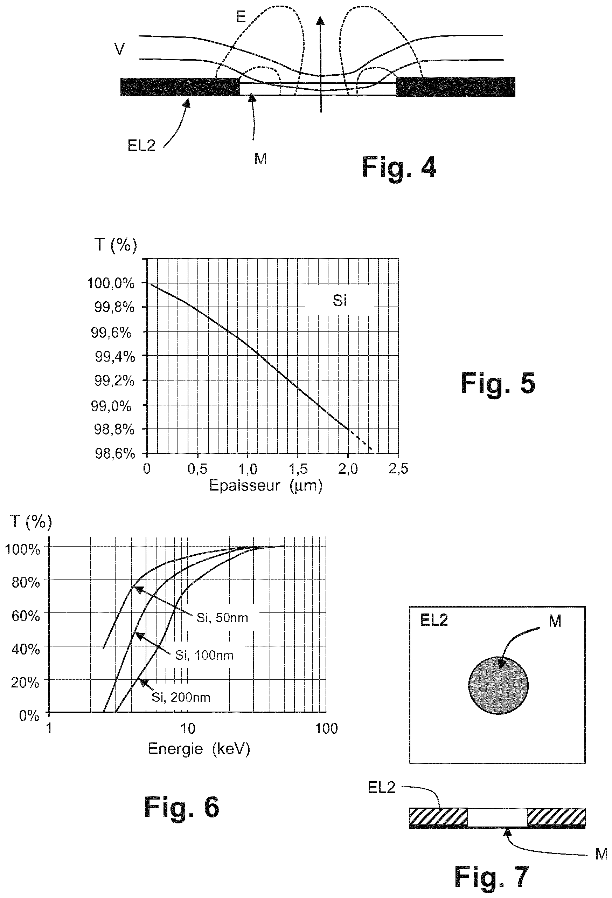

La focalisation est d'autant meilleure que le champ radial varie plus au cours de la traversée de l'ouverture de l'électrode central et il s'avère que l'utilisation de la membrane faiblement conductrice à forte permittivité diélectrique donne les meilleurs résultats.La figure 4 représente la configuration des lignes de potentiel V et des lignes de champ E à proximité immédiate de la membrane à forte permittivité diélectrique. La flèche indique le sens de passage des électrons à focaliser. Les lignes de champ sont très différentes de ce qu'elles seraient en l'absence de membrane ou en présence d'une membrane conductrice.

Le tableau ci-dessous donne à titre d'exemple les valeurs de longueurs focales obtenues en fonction de la valeur du potentiel V3 appliqué à l'électrode EL3, les autres potentiels restant constants (V1 = 10 volts, V2 = 200 volts), ceci pour trois valeurs différentes de la permittivité diélectrique relative $\varepsilon_r$ de la membrane : $\varepsilon_r$ = 1 (équivalent d'une absence de membrane), $\varepsilon_r$ = 3,9 (membrane en nitrure de silicium), $\varepsilon_r$ = 11,9 (membrane en silicium de dopage inférieur à $10^{19}$ at/cm$^3$). L'épaisseur de la membrane est de moins de 1 micromètre.

| V1 = 10 volts, V2 = 200 volts | | | |
|---|---|---|---|
| | Distance focale pour le vide, un isolant SiN, et le silicium | | |
| | Vide | SiN | Si |
| V3 | $\varepsilon_r$ = 1 | $\varepsilon_r$ = 3,9 | $\varepsilon_r$ = 11,9 |
| 500 volts | 8,80 mm | 4,02 mm | 3,78 mm |
| 2500 volts | 0,875 mm | 0,727 mm | 0,700 mm |
| 5000 volts | 0,644 mm | 0,550 mm | 0,534 mm |

On comprend avec ce tableau qu'on pourrait réduire la longueur focale en l'absence de membrane au-dessous de 0,644 mm en augmentant la tension V3 au-delà de 5000 volts. Mais une augmentation de la tension V3 aboutirait à un risque de claquage. Mais on peut diminuer la longueur focale à 0,534 mm par la présence d'une membrane de permittivité suffisamment élevée, sans augmenter la tension V3.

De la même manière, on déduit de ce tableau que si on recherche une longueur focale de 0,644 mm, on peut l'obtenir avec une tension V3 d'environ 3000 volts et non 5000 volts si une membrane mince de silicium est utilisée.

L'utilisation d'une telle membrane suppose qu'elle soit suffisamment transparente aux électrons. Par "suffisamment transparente", on entend une transparence de préférence supérieure à 98%. Pour un matériau donné, cette transparence dépend à la fois de l'épaisseur de la membrane et de l'énergie des électrons du faisceau : elle diminue avec l'épaisseur et augmente avec l'énergie.

La transparence dépend également du matériau et principalement du numéro atomique des constituants de ce matériau, la transparence diminuant avec l'augmentation du numéro atomique.

La transparence peut être modélisée à partir d'équations telles que l'équation de Bethe qui représente la perte d'énergie (-dE) d'un faisceau d'électrons le long d'un parcours élémentaire (dS) à travers une couche de matériau :

$$-\frac{dE}{dS} = \frac{4\pi NZ}{(4\pi\varepsilon_0)^2} \cdot \frac{e^4}{2E_0} \ln\left(\frac{4E_0}{I}\right)^{1/2}$$

$\varepsilon_o$ est la permittivité du vide,

e est la charge de l'électron,

N est le nombre d'atomes par unité de volume ; ce nombre est lié à la densité du matériau, plus grande si N est plus grand, plus petite si N est plus petit,

Z est le numéro atomique du matériau,

$E_0$ est l'énergie des électrons incidents,

I est l'énergie moyenne d'ionisation du matériau dans lequel se propagent les électrons ; elle dépend du numéro atomique et elle est définie de manière empirique ; une valeur donnée dans la littérature est parfois, en electron-volts, I = (9,76 + 58,8x$Z^{1,19}$) pour Z supérieur ou égal à 13, ou parfois une expression simplifiée I = 11,5xZ.

Il est donc préférable de réaliser la membrane avec des constituants à faible numéro atomique. Le silicium est particulièrement intéressant du fait qu'on maîtrise bien les procédés technologiques de dépôt et gravure de ce matériau très utilisé en microélectronique. L'arséniure de gallium et l'alliage semiconducteur SiGe sont deux autres matériaux semiconducteurs qui peuvent être envisagés.

La figure 5 représente à titre d'exemple la variation du coefficient de transmission T en fonction de l'épaisseur de la membrane pour un faisceau d'énergie 50 keV et une membrane en silicium. Le coefficient de transmission reste au-dessus de 98% aux environs de 2 micromètres d'épaisseur.

La figure 6 représente la variation du coefficient de transmission en fonction de l'énergie du faisceau pour différentes épaisseurs de membranes en silicium Si. On voit sur ces courbes qu'il est préférable d'utiliser des membranes d'épaisseur inférieure à 50 nanomètres si l'énergie est inférieure à 20 keV, pour avoir une transmission supérieure à 98%.

La figure 7 représente l'électrode centrale EL2 avec son ouverture fermée par la membrane M en matériau semiconducteur. La membrane peut être réalisée par exemple par gravure profonde de la face arrière d'une plaque de silicium pour ne conserver qu'un film superficiel. Par exemple, la plaque de silicium peut être une plaque SOI, c'est-à-dire un substrat de silicium recouvert d'une couche isolante elle-même recouverte d'une couche superficielle de silicium très fine ; la gravure profonde par la face arrière peut éliminer localement le substrat et la couche isolante jusqu'à ne garder que la couche de silicium superficielle qui sert alors de membrane. Le silicium de la couche superficielle est alors du silicium peu dopé, pour être suffisamment isolant électriquement. Typiquement, le niveau de dopage est compris entre $10^{14}$ et $10^{19}$ atomes/cm$^3$, de préférence entre $10^{14}$ et $10^{18}$ atomes/cm$^3$. Le substrat de silicium peut être en silicium fortement dopé ou dégénéré (avec une concentration de donneurs ou d'accepteurs supérieure à $10^{19}$ atomes/cm$^3$) donc conducteur pour constituer l'électrode elle-même dans laquelle la gravure profonde constitue l'ouverture fermée par la membrane. Alternativement, la plaque de silicium peut être rapportée sur l'électrode en faisant coïncider l'ouverture de la plaque et la membrane formée à partir de la plaque.

D'une manière générale, les lentilles électrostatiques sont affectées d'aberrations de plusieurs types : aberrations géométriques et notamment aberrations sphériques, aberrations chromatiques, ou encore aberrations d'astigmatisme. Les aberrations géométriques sont d'autant plus importantes que le grandissement du système de focalisation est élevé et la sensibilité à ces aberrations est particulièrement forte dans les microscopes électroniques. Les aberrations sphériques sont dues à ce qu'une lentille électrostatique est toujours plus convergente pour les trajectoires périphériques que pour les trajectoires centrales. Les aberrations chromatiques sont dues à ce que la distribution d'énergie n'est pas uniforme dans le faisceau, certains électrons ayant plus d'énergie que d'autres ; elles sont également d'autant plus significatives que le grandissement du système optique est élevé. Les aberrations d'astigmatisme sont dues à des défauts de symétrie ou d'alignement dans la lentille ; la convergence n'est pas la même selon la direction initiale des électrons et ce défaut constitue une aberration d'astigmatisme.

Ces aberrations peuvent être corrigées en tout ou en partie par la structure ou la forme de la membrane semiconductrice. Les corrections précises ne peuvent bien entendu être déterminées que par des simulations à l'aide de logiciels qui évaluent les champs électrostatiques et la trajectoire des électrons. Mais les exemples suivants indiquent des possibilités de structuration de membrane qui ont un effet sur les aberrations par l'intermédiaire des différences locales de trajectoires des électrons en fonction de l'endroit où ils traversent la membrane. Ces différences de trajectoires résultent de la distribution de permittivités diélectriques qui est modifiée par la modification de structure de la membrane.

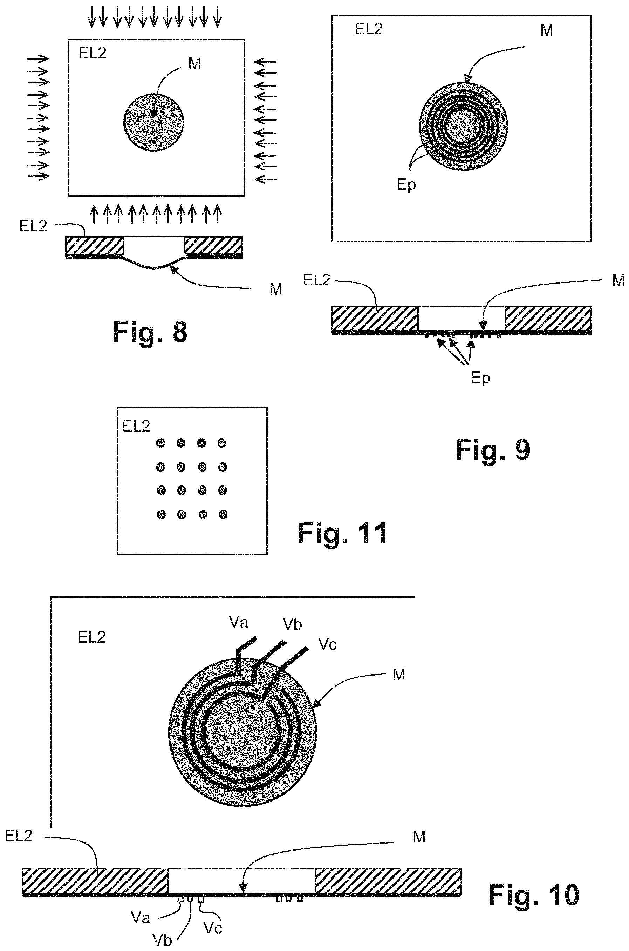

Tout d'abord, la membrane peut être bombée plutôt que plane comme cela est représenté sur la figure 8. On sait faire des membranes bombées en forme de cloche ou de calotte sphérique ou à peu près sphérique par une application de contraintes périphériques tout autour de la plaque dont l'ouverture est fermée par la membrane. Pour une plaque de silicium avec une ouverture fermée par une membrane de silicium, les contraintes de compression sont appliquées sur tous les côtés de la plaque selon les flèches représentées sur la figure 8. Les contraintes peuvent être d'origine mécanique ou piézoélectrique.

Des ouvertures locales dans la membrane plane ou bombée peuvent avoir une action sur la distribution des champs électriques donc sur les trajectoires d'électrons. Ces ouvertures peuvent être distribuées de manière à corriger en partie certaines des aberrations. Les ouvertures peuvent en particulier être disposées avec une répartition qui n'est pas uniforme sur la surface de la membrane mais qui au contraire est faite selon une géométrie à plusieurs pôles (quadrupolaire, ou hexapolaire ou octopolaire), c'est-à-dire qui présente des variations en fonction d'une position angulaire dans le plan de la membrane. La géométrie de la distribution des trous peut également présenter des variations qui sont fonction d'une distance radiale par rapport au centre du faisceau, en plus ou à la place des variations selon la position angulaire.

Des modifications locales d'épaisseur de la membrane peuvent également avoir un effet. Ces modifications peuvent être produites soit par gravure locale du matériau de la membrane sur une partie de l'épaisseur de la membrane soit par un dépôt d'une autre couche, isolante ou semiconductrice ou conductrice sur la membrane et enlèvement local de cette couche. La figure 9 représente une membrane avec une épaisseur localement modifiée ; dans le cas représenté il s'agit de surépaisseurs Ep disposées selon des cercles concentriques, donc avec une symétrie circulaire, mais là encore la distribution des surépaisseurs peut être faite en privilégiant certaines directions radiales et certaines distances, par exemple pour constituer une géométrie à plusieurs pôles (notamment une géométrie quadrupolaire ou hexapolaire ou octopolaire dont on sait qu'elle a une influence sur la correction des aberrations sphériques des lentilles à symétrie de révolution et en partie sur la correction des aberrations chromatiques et d'astigmatisme).

La figure 10 représente une autre manière de structurer la membrane : on dépose des portions d'une couche conductrice sur la membrane et on leur applique des potentiels dont on peut déterminer l'influence sur le trajet des électrons. En particulier, on peut appliquer des potentiels qui modifient les champs électriques d'une manière différente selon l'éloignement par rapport au centre du faisceau. Sur la figure 10, les électrodes formées sur la membrane par dépôt et gravure d'une couche conductrice sont circulaires et concentriques et des potentiels Va, Vb, Vc leur sont appliqués. La surface occupée par les électrodes doit être au total assez faible par rapport à la surface de l'ouverture pour ne pas réduire exagérément la transparence de la membrane aux électrons (sauf si les électrodes sont d'épaisseur vraiment très faible telle que quelques nanomètres et en matériau léger tel que l'aluminium Al ou l'alliage AlSi) ; l'épaisseur de la couche conductrice doit être aussi réduite que possible pour la même raison.

Les électrodes pourraient également avoir une géométrie multipolaire (notamment quadrupolaire ou hexapolaire ou octopolaire) pour agir sur l'une ou l'autre des différentes sortes d'aberrations constatées. Par exemple, quatre électrodes distinctes en arc de cercle, opposées deux à deux et réparties le long d'un cercle, permettent de créer une structure quadrupolaire pouvant agir sur l'astigmatisme par application de deux différences de potentiel différentes sur les couples d'électrodes opposées.

L'ouverture elle-même de l'électrode centrale est en principe circulaire mais pourrait aussi être elliptique, rectangulaire, ou multipolaire, la forme jouant également un rôle dans la correction des aberrations en supprimant la symétrie de révolution.

Enfin, pour des applications multifaisceaux, tout ce qui vient d'être dit peut être appliqué à autant d'ouvertures qu'il y a de faisceaux. La figure 11 représente l'électrode EL2 percée de plusieurs trous obturés chacun par une membrane semiconductrice respective pour former sur la même électrode plane plusieurs lentilles électrostatiques. Les électrodes EL1 et EL3 sont également percées d'ouvertures en correspondance avec les ouvertures de l'électrode EL2 dans l'axe de chacun des faisceaux d'électrons.

**Revendications**

1. Lentille électrostatique pourvue d'au moins une électrode conductrice (EL2) percée d'au moins une ouverture de passage d'un faisceau d'électrons, dans laquelle cette ouverture de passage est fermée au moins partiellement par une membrane mince (M) de matériau semi-conducteur non dégénéré, transparent aux électrons du faisceau et de permittivité diélectrique relative supérieure à 10, **caractérisée en ce que** ladite membrane est électriquement reliée à ladite électrode conductrice.

2. Lentille électrostatique selon la revendication 1, **caractérisée en ce que** le matériau semiconducteur est du silicium de dopage inférieur à $10^{19}$ atomes/cm$^3$ ou de l'arséniure de gallium ou du silicium-germanium SiGe.

3. Lentille électrostatiques selon l'une des revendications 1 et 2, **caractérisée en ce que** l'épaisseur de la membrane est inférieure à 2 micromètres.

4. Lentille électrostatique selon l'une des revendications 1 à 3, **caractérisée en ce que** la membrane est bombée.

5. Lentille électrostatique selon l'une des revendications 1 à 4, **caractérisée en ce que** la membrane est structurée par des ouvertures ou des modulations d'épaisseur ou des dépôts de couches isolantes, conductrices ou semiconductrices.

6. Lentille électrostatique selon la revendication 5, **caractérisée en ce que** la structuration de la membrane a une configuration multipolaire.

7. Lentille électrostatique selon l'une des revendications précédentes, **caractérisée en ce que** l'électrode comporte plusieurs ouvertures fermées chacune par une membrane semiconductrice pour la focalisation de plusieurs faisceaux d'électrons.

**Patentansprüche**

1. Elektrostatische Linse mit mindestens einer leitfähigen Elektrode (EL2), welche durch mindestens eine Durchgangsöffnung für einen Elektronenstrahl durchbrochen ist, bei welcher diese Durchgangsöffnung mindestens teilweise durch eine feine Membran (M) aus nicht degeneriertem Halbleitermaterial verschlossen ist, welches für die Elektronen des Strahls transparent ist und eine relative dielektrische Permittivität über 10 besitzt, **dadurch gekennzeichnet, dass** die Membran elektrisch mit der leitfähigen Elektrode verbunden ist.

2. Elektrostatische Linse nach Anspruch 1, **dadurch gekennzeichnet, dass** das Halbleitermaterial Silizium mit einer Dotierung unter $10^{19}$ Atomen/cm$^3$ oder Galliumarsenid oder Silizium-Germanium SiGe ist.

3. Elektrostatische Linse nach einem der Ansprüche 1 und 2, **dadurch gekennzeichnet, dass** die Dicke der Membran unter 2 Mikrometern liegt.

4. Elektrostatische Linse nach einem der Ansprüche 1 bis 3, **dadurch gekennzeichnet, dass** die Membran gewölbt ist.

5. Elektrostatische Linse nach einem der Ansprüche 1 bis 4, **dadurch gekennzeichnet, dass** die Membran durch Öffnungen oder Dickenmodulationen oder Ablagerungen von isolierenden, leitfähigen oder halbleitenden Schichten strukturiert ist.

**6.** Elektrostatische Linse nach Anspruch 5, **dadurch gekennzeichnet, dass** die Strukturierung der Membran eine multipolare Konfiguration aufweist.

**7.** Elektrostatische Linse nach einem der vorhergehenden Ansprüche, **dadurch gekennzeichnet, dass** die Elektrode mehrere Öffnungen beinhaltet, welche jeweils durch eine halbleitende Membran zur Fokalisierung mehrerer Elektronenstrahlen verschlossen sind.

**Claims**

**1.** An electrostatic lens provided with at least one conductive electrode (EL2) pierced with at least one aperture for passing an electron beam, wherein this passing aperture is closed at least partially by a thin membrane (M) of a non-degenerate semiconductor that is transparent to the electrons of the beam and of relative dielectric permittivity higher than 10, **characterized in that** said membrane is electrically connected to said conductive electrode.

**2.** The electrostatic lens according to claim 1, **characterized in that** the semiconductor is silicon of doping density lower than $10^{19}$ atoms/cm$^3$ or gallium arsenide or silicon-germanium SiGe.

**3.** The electrostatic lens according to any one of claims 1 and 2, **characterized in that** the thickness of the membrane is smaller than 2 microns.

**4.** The electrostatic lens according to any one of claims 1 to 3, **characterized in that** the membrane is curved.

**5.** The electrostatic lens according to any one of claims 1 to 4, **characterized in that** the membrane is structured with apertures or thickness modulations or by depositing insulating, conductive or semiconductor layers.

**6.** The electrostatic lens according to claim 5, **characterized in that** the structuring of the membrane has a multipolar configuration.

**7.** The electrostatic lens according to any one of the preceding claims, **characterized in that** the electrode includes a plurality of apertures each closed with a semiconductor membrane in order to focus a plurality of electron beams.

Fig. 1

Fig. 2

Fig. 3

Fig. 4

Fig. 5

Fig. 6

Fig. 7

**Fig. 8**

**Fig. 9**

**Fig. 11**

**Fig. 10**

**EP 3 005 397 B1**

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- EP 0500179 A
- EP 1492151 A
- EP 1811540 A
- US 4567399 A
- WO 2004021391 A